# EUROPÄISCHE PATENTSCHRIFT

(11) **EP 2 686 895 B1**
(45) Veröffentlichungstag und Bekanntmachung des Hinweises auf die Patenterteilung: **12.04.2017**
(21) Anmeldenummer: 12701131.0
(22) Anmeldetag: 26.01.2012
(51) Int. Cl.: H01L 41/273, H01L 41/083

(54) **VERFAHREN ZUR HERSTELLUNG VON PIEZOELEKTRISCHEN AKTUATORBAUELEMENTEN**
METHOD FOR PRODUCING PIEZOELECTRIC ACTUATOR COMPONENTS
PROCÉDÉ DE FABRICATION DE COMPOSANTS ACTIONNEURS PIÉZOÉLECTRIQUES

(30) Priorität: 16.03.2011 DE 102011014156
(43) Veröffentlichungstag der Anmeldung: 22.01.2014
(73) Patentinhaber: Epcos AG, 81669 München (DE)
(72) Erfinder: DERNOVSEK, Oliver, A-8501 Lieboch (AT); GLAZUNOV, Alexander, A-8530 Deutschlandsberg (AT)
(74) Vertreter: Epping - Hermann - Fischer
(86) Internationale Anmeldenummer: PCT/EP2012/051225
(87) Internationale Veröffentlichungsnummer: WO 2012/123155

(56) Entgegenhaltungen:
- DE-A1- 10 205 877
- DE-A1-102009 043 000
- JP-A- H11 304 371
- US-A- 5 527 501
- US-A1- 2002 012 600

## Beschreibung

Die Erfindung betrifft ein Verfahren zur Herstellung von piezoelektrischen Aktuatorbauelementen, bei dem eine Entkohlung und eine Sinterung der Aktuatorbauelemente erfolgt.

Bei der Herstellung eines piezoelektrischen Aktorbauelements werden zunächst piezoelektrische Schichten mit einem leitfähigen Material beschichtet, übereinander gestapelt und anschließend verpresst. Nachfolgend werden aus dem so entstandenen Materialblock die Aktorbauelemente vereinzelt. Anschließend werden während eines Entkohlungsprozesses organische Bestandteile, die im Material der piezoelektrischen Schichten oder der leitfähigen Schichten des Aktors enthalten sind, beispielsweise Binder in den Keramikfolien und metallischen Innenelektrodenpasten, durch Ausbrennen aus dem Körper des Aktors entfernt. Danach wird der zunächst noch poröse Körper des Aktors durch einen Sinterungsprozess zu einem dichten Körper umgewandelt.

Während des Entkohlens beziehungsweise Entbinderns und des Sinterns wirken sich die vorherrschenden Umgebungsbedingungen, beispielsweise die Temperatur, der Sauerstoffpartialdruck und der Bleioxidpartialdruck (PbO-Partialdruck) bei einer bleihaltigen Keramik der piezoelektrischen Schichten, entscheidend auf die Qualität der fertigen Bauteile aus. Die Umgebung der Aktorbauelemente bestimmt unter anderem den Beitrag der thermischen Energie auf jedes einzelnes Bauteil und den Sauerstoffpartialdruck, dem jedes Bauteil ausgesetzt ist. Insbesondere die Rolle des Sauerstoffpartialdrucks ist kritisch für die Qualität von vielschichtigen Aktoren. Bei der Entkohlung bestimmt der Sauerstoffpartialdruck beispielsweise die Zerfallsrate von organischen Komponenten im Körper des Aktors. Dabei muss sichergestellt werden, dass der Sauerstoffpartialdruck derart eingestellt ist, dass einerseits die organischen Bestandteile aus dem Körper des Aktors entfernt werden, andererseits der Sauerstoff jedoch keine Oxidation der inneren Elektrodenschichten des Aktors bewirkt. Bei der Entkohlung und Sinterung wirkt der Sauerstoffpartialdruck auf Reaktionen zwischen metallischen Elektrodenschichten und den keramischen Schichten, die von Natur her verschiedene Materialtypen, insbesondere Metall oder Oxidmaterial, sind. Bei der Sinterung wirkt sich des Weiteren die Umgebung der Bauteile, insbesondere die Temperatur und die Atmosphäre, auf den Bleioxid(PbO)-Abdampf aus der piezoelektrischen Keramik auf Basis von Blei-Zirkon-Titanat (PZT) aus.

Eine inhomogene Umgebung während des Entbinderungs- beziehungsweise Sintervorgangs führt zur Streuung von elektrischen oder mechanischen Kenngrößen der einzelnen Aktorbauteile. Es können beispielsweise Schwankungen der Auslenkung und des Isolationswiderstandes der einzelnen Bauteile, Abweichungen in der Geometrie der einzelnen Bauteile, insbesondere der Breite oder der Krümmung der Bauteile, auftreten. Des Weiteren können inhomogene Umgebungsbedingungen zu Schwankungen der Kontinuität der Innenelektroden, zur Bildung von Rissen in einzelnen Bauteilen und letztendlich zu Schwankungen in der Zuverlässigkeit der Bauteile im späteren Betrieb führen.

Die Druckschrift DE 102009043000 A1 betrifft ein piezoelektrisches Vielschichtbauelement, das einen Stapel aus piezoelektrischen Schichten und dazwischen angeordnete Innenelektroden aufweist. Zur Fertigung des piezoelektrischen Vielschichtbauelements wird ein Stapel aus piezoelektrischen Grünfolien, die ein Keramikpulver, ein organisches Bindemittel und ein Lösungsmittel enthalten, nach dem Stapeln verpresst und gesintert wird.

Die Druckschrift US 2002/0012600 A1 betrifft ein Verfahren zur Herstellung eines gesinterten Magneten aus seltenen Erden. Zur Sinterung kann eine Vielzahl von Grünkörpern der Magnete in einem Sinterofen auf Trägerplatten nebeneinander angeordnet werden, wobei die Trägerplatten in dem Sinterofen übereinander gestapelt sind.

Es besteht ein Bedarf an einem Verfahren zur Herstellung von piezoelektrischen Aktorbauelementen, mit dem weitgehend sichergestellt werden kann, dass während der Herstellung der Bauelemente, insbesondere während der Entkohlung beziehungsweise Sinterung, homogene Umgebungsbedingungen für die einzelnen piezoelektrischen Aktorbauelemente vorherrschen.

Ein derartiges Verfahren ist in den Patentansprüchen angegeben.

Eine Ausführungsform eines Verfahren zur Herstellung von piezoelektrischen Aktorbauelementen umfasst das Bereitstellen einer Vielzahl von Stapelanordnungen piezoelektrischer Bauelemente, wobei die Stapelanordnungen jeweils piezoelektrische Schichten und leitfähige Schichten umfassen, und wobei die piezoelektrischen Schichten in einer Längsrichtung der Stapelanordnung übereinander gestapelt sind und die leitfähigen Schichten zwischen den piezoelektrischen Schichten angeordnet sind. Die Vielzahl der Stapelanordnungen ist auf einer Trägervorrichtung derart angeordnet, dass die Stapelanordnungen jeweils in der Längsrichtung der Stapelanordnungen nebeneinander liegend auf der Trägervorrichtung angeordnet sind. Die Vielzahl der Stapelanordnungen wird entbindert und/oder gesintert, wobei die Stapelanordnungen während des Entbinderns und/oder Sinterns auf der Trägervorrichtung nebeneinander liegend angeordnet sind.

Die Stapelanordnungen liegen mit ihrer Längsachse parallel zur Oberfläche der Trägervorrichtung auf der Trägervorrichtung, die beispielsweise als eine Trägerplatte ausgebildet sein kann. Der liegende Aufbau der Aktuatoren auf der Trägervorrichtung ist insbesondere dann bevorzugt zu verwenden, wenn Aktuatoren mit großer Länge und kleiner Breite, beispielsweise mit einem Längen- zu Breitenverhältnis von 1 zu 7 bis 1 zu 10 verwendet werden.

Die Stapelanordnungen werden auf der Trägerplatte in Aufnahmeeinrichtungen angeordnet. Die Aufnahmeeinrichtungen können auf der Trägervorrichtung nebeneinander angeordnet werden. Die Aufnahmeeinrichtungen können beispielsweise als ein gefaltetes Netz, ein Gitter oder ein gelochtes Blech, insbesondere aus Kupfer, ausgebildet sein. In Nestern dieses Netzes werden die Stapelanordnungen der einzelnen Aktuatoren eingelegt, so dass eine Vielzahl von Stapelanordnungen auf der Trägervorrichtung nebeneinander liegend angeordnet sind. Die Stapelanordnungen können jeweils von einer Abdeckeinrichtung abgedeckt werden, die ebenfalls aus einem Material ausgebildet sind, das als Netz oder Gitter geformt ist, oder als ein gelochtes Blech, insbesondere aus Kupfer, ausgeführt ist. Dieser Aufbau führt dazu, dass auf jeden Aktor, der zwischen einer der Aufnahmeeinrichtungen und einer der Abdeckeinrichtungen angeordnet ist, die gleichen Umgebungsbedingungen wirken. Da alle vier Seitenflächen jedes Aktors den gleichen Umgebungsbedingungen ausgesetzt sind, wird der Sauerstoffpartialdruck während der Entkohlung und Sinterung und der Bleioxidpartialdruck während der Sinterung homogen über sämtliche der vier Seiten jedes Aktors verteilt.

Wenn die Aufnahmeeinrichtungen beziehungsweise die Abdeckeinrichtungen aus Kupfer ausgeführt sind, stellt sich des Weiteren ein konstanter Partialdruck von Kupfer und Kupferoxiden während des Sintervorgangs an den Seitenflächen jedes Aktors ein. Da jedes Aktorbauelement mit seinen Seitenflächen entweder an Auflageflächen der Aufnahmeeinrichtung oder an Auflageflächen der Abdeckeinrichtung anliegt, werden mögliche Schwankungen im Sauerstoffpartialdruck während des Sintervorgangs stabilisiert. Wenn das Aktorbauelement Innenelektrodenschichten aus Kupfer aufweist, lassen sich die Innenelektroden durch eine Aufnahmeeinrichtung und/oder eine Abdeckeinrichtung aus Kupfer, die beispielsweise mit Öffnungen in ihren Auflageflächen gitterförmig oder netzartig ausgebildet sind, vor einer Oxidation schützen.

Durch die Aufnahmeeinrichtungen, die aus einem netzartig oder gitterartig geformten Material ausgebildet sein können, und auf der Trägervorrichtung, beispielsweise einer Trägerplatte, angeordnet sind, können Wechselwirkungen zwischen der Stapelanordnung des Aktors und dem Material der Trägervorrichtung vermieden werden.

Die Aufnahmeeinrichtungen und die Abdeckeinrichtungen weisen in ihren Auflageflächen, an denen die Seitenflächen der Stapelanordnungen in den Aufnahmeeinrichtungen und Abdeckeinrichtungen aufliegen, Öffnungen beziehungsweise Löcher auf. Bei Verwendung von derartigen netzartigen oder gitterförmigen Auflageflächen der Aufnahme- und Abdeckeinrichtungen oder bei Verwendung eines Lochblechs für die Aufnahmeeinrichtungen und die Abdeckeinrichtungen sorgen die Löcher in den Auflageflächen der Aufnahme- und Abdeckeinrichtungen für eine gute und gleichmäßige Zufuhr von Prozessgas zu allen vier Seiten des Aktorstapels.

Es können mehrere Trägerplatten, auf denen die Bauteile liegend in den Aufnahmeeinrichtungen angeordnet sind, übereinander gestapelt werden. Abstandsbolzen können der Separation der einzelnen Trägerplatten voneinander dienen. Die übereinander angeordneten Trägervorrichtungen mit den darauf angeordneten Aktuatoren können mit einer Abdeckeinrichtung, beispielsweise einem Deckel, abgedeckt werden. Eine derartige Abdeckeinrichtung sollte allerdings nur bei der Sinterung angewandt werden. Bei einem Entkohlungsvorgang würde die Abdeckeinrichtung den Abtransport von Abfallprodukten von organischen Bindern verhindern. Die Abdeckeinrichtung kann als ein Deckel aus Kupfer ausgebildet sein, was zu einer weiteren Stabilisierung der Atmosphäre im Ofen führt.

Gemäß einer weiteren Ausführungsform des Verfahrens zur Herstellung der piezoelektrischen Aktorbauelemente werden die Stapelanordnungen der einzelnen Aktuatoren während der Entkohlung und Sinterung in einem Ofen auf Trägervorrichtungen die eine Vielzahl von kreissegmentförmigen Trägerelementen umfassen, angeordnet. Die kreissegmentförmigen Trägerelemente können im Ofen nebeneinander in einer Ebene zu einem Kreis angeordnet werden. Mehrere Ebenen einer solchen Anordnung können auch übereinander in einem Entbinderungs- beziehungsweise Sinterungsofen angeordnet werden. Die einzelnen Abstandsebenen können beispielsweise mit Abstandsbolzen zueinander beabstandet angeordnet werden. Die einzelnen Stapelanordnungen der Aktuatoren werden auf jeder Trägervorrichtung nebeneinander liegend angeordnet.

Zur Verbesserung der Homogenität der Umgebung können die Trägervorrichtungen zusätzlich mit jeweils einem Abdeckelement abgedeckt werden. Die Abdeckelemente weisen jeweils Seitenteile, die auf die Trägervorrichtung aufgesetzt werden, und ein Oberteil, das beabstandet zu der Trägervorrichtung angeordnet ist, auf. Das Oberteil der Abdeckelemente bildet gleichzeitig die Trägervorrichtung einer weiteren Ebene, auf der weitere Stapelanordnungen von Aktuatorbauelementen angeordnet werden können. Somit kann bei der Verwendung der Abdeckelemente über einer Trägervorrichtung auf das Vorsehen von Abstandsbolzen zwischen den Trägervorrichtungen verschiedener Ebenen verzichtet werden.

Die Abdeckelemente können die Form eines Kreissegments aufweisen. Jedes dieser Segmente kann vier Seitenteile aufweisen, so dass das Abdeckelement von allen vier Seiten geschlossen ist. Ein Abdeckelement kann auch nur lediglich zwei Seitenflächen aufweisen, wobei die Seitenflächen zu den Nachbarsegmenten fehlen. Bei dieser Ausführungsform lassen sich die Abdeckelemente derart aneinander reihen, dass ein kontinuierlicher Ring von Abdeckelementen entsteht, was einem homogenen Aufbau entspricht.

Die Erfindung wird im Folgenden anhand von Figuren, die Ausführungsbeispiele der vorliegenden Erfindung zeigen, näher erläutert.

Es zeigen:
Figur 1 eine Ausführungsform einer Stapelanordnung eines piezoelektrischen Aktorbauelements,
Figur 2 eine Ausführungsform des Verfahrens zur Herstellung von piezoelektrischen Aktorbauelementen, bei dem die piezoelektrischen Aktorbauelemente in Aufnahmeeinrichtungen liegend auf einer Trägervorrichtung angeordnet sind,
Figur 3 eine weitere Ausführungsform des Verfahrens zur Herstellung von piezoelektrischen Aktorbauelementen, bei dem die Aktuatorbauelemente auf mehreren übereinander gestapelten Trägervorrichtungen angeordnet sind,
Figur 4 eine weitere Ausführungsform eines Verfahrens zur Herstellung von piezoelektrischen Aktuatorbauelementen, bei dem die Aktuatorbauelemente auf kreissegmentförmigen Trägerelementen einer Trägervorrichtungen angeordnet sind,
Figur 5A eine Ausführungsform eines Abdeckelements zur Abdeckung eines kreissegmentförmigen Trägerelements einer Trägervorrichtung,
Figur 5B eine weitere Ausführungsform eines Abdeckelements zur Abdeckung eines kreissegmentförmigen Trägerelements einer Trägervorrichtung.

Bei der Herstellung von piezoelektrischen Aktorbauelementen werden piezoelektrische Schichten mit einem leitfähigen Material beschichtet und übereinander gestapelt. Die gestapelten Lagen werden anschließend zu einem Materialblock verpresst. Aus einem solchen Materialblock werden im Grünzustand die einzelnen piezoelektrischen Aktorbauelemente vereinzelt.

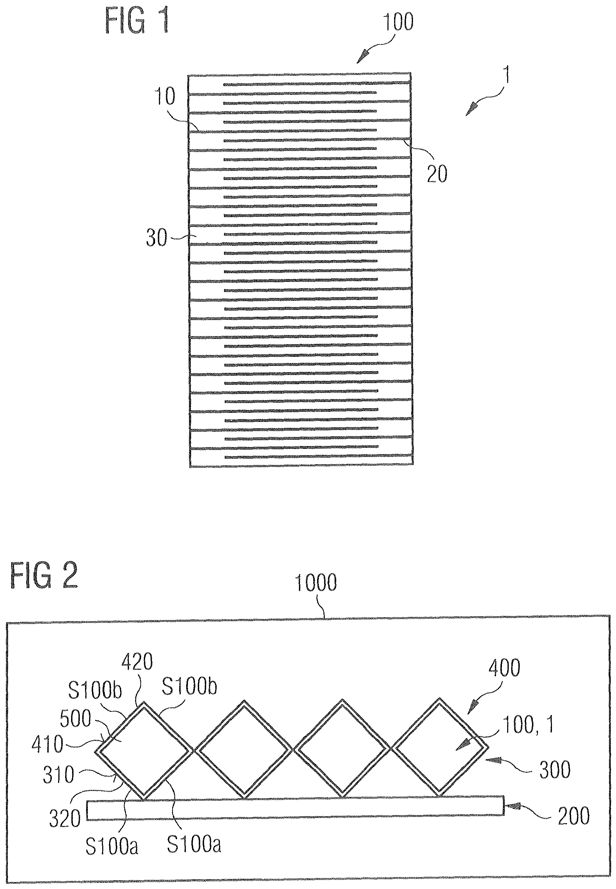

Figur 1 zeigt eine Stapelanordnung 100 eines solchen piezoelektrischen Aktorbauelements 1 nach dem Vereinzeln. Der Schichtstapel weist eine Vielzahl von übereinander geschichteten piezoelektrischen Schichten 30 auf. Zwischen den einzelnen piezoelektrischen Schichten sind die von dem leitfähigen Material gebildeten Elektrodenschichten 10 und 20 angeordnet. Die piezoelektrischen Schichten 30 und die zwischen ihnen angeordneten leitfähigen Schichten 10, 20 sind in einer Längsrichtung der Stapelanordnung 100 übereinander gestapelt.

Die piezoelektrischen Schichten 30 können beispielsweise Folien einer piezoelektrischen Keramik auf Basis von Blei-Zirkon-Titanat (PZT) sein. Die leitfähigen Schichten 10 und 20 können aus Kupfer ausgeführt sein. Zusätzlich weist der Materialstapel organische Bestandteile, beispielsweise Binder, in den Keramikfolien 30 und den metallischen Innenelektrodenpasten 10 und 20, auf. Zur Weiterverarbeitung des Grünkörpers werden die organischen Bestandteile während eines Entkohlungs- beziehungsweise Entbinderungsvorgangs durch Ausbrennen aus dem Körper des Aktorbauelements entfernt. Nachfolgend wird die Stapelanordnung 100, die zunächst noch einen porösen Körper darstellt, durch einen Sinterungsprozess zu einem dichten Körper umgewandelt.

Für die Qualität der Aktorbauelemente, insbesondere deren elektrische und mechanische Kenngrößen, ist es während dem Entbindungs- und Sinterungsvorgang wichtig, dass sämtliche darin prozessierten Aktorbauelemente homogenen Umgebungsbedingungen ausgesetzt sind. Von großer Bedeutung ist, wie jede einzelne Stapelanordnung eines Aktorbauelements auf einer Trägervorrichtung aufgebaut wird und wie eine Vielzahl dieser Stapelanordnungen in einem Entbinderungs- beziehungsweise Sinterungsofen angeordnet werden.

Figur 2 zeigt eine Trägervorrichtung 200, die beispielsweise als eine Trägerplatte ausgebildet sein kann. Auf der Trägerplatte 200 sind eine Vielzahl von Stapelanordnungen 100 in Längsrichtung der Stapelanordnungen liegend angeordnet. Die einzelnen Stapelanordnungen werden von Aufnahmeeinrichtungen 300 gehalten. Die Aufnahmeeinrichtungen 300 werden auf der Trägerplatte 200 angeordnet. Sie weisen jeweils Auflageflächen 310 auf, die untereinander verbunden sind. Die Auflageflächen der Aufnahmeeinrichtungen können beispielsweise dreieck- beziehungsweise zick-zack-förmig aneinander gereiht gefaltet sein.

Die Stapelanordnungen 100 der piezoelektrischen Aktorbauelemente 1 werden mit ihren Seitenflächen S100a in die einzelne Aufnahmeeinrichtungen 300 eingelegt. Die Seitenflächen S100a der Aktorbauelemente berühren dabei die Auflageflächen 310 der Aufnahmeeinrichtungen. Die Auflageflächen 310 weisen Öffnungen beziehungsweise Löcher 320 auf. Die Aufnahmeeinrichtungen können beispielsweise aus einem metallischen Material, beispielsweise aus Kupfer, ausgebildet sein, wobei das Material eine netzförmige oder gitterartige Struktur aufweist. Die einzelnen Auflageflächen 310 der Aufnahmeeinrichtungen können auch aus miteinander verbundenen gelochten Blechen aufgebaut sein.

Nach dem Einlegen der einzelnen Stapelanordnungen 100 der piezoelektrischen Bauelemente können Abdeckeinrichtungen 400 auf die aus den Aufnahmeeinrichtungen 300 herausragenden Seitenflächen S100b der Aktorbauelemente 1 gelegt werden. Dabei berühren Auflageflächen 410 der Abdeckeinrichtungen 400 die Seitenflächen S100b der Stapelanordnungen 100 der piezoelektrischen Aktorbauelemente 1.

Die Abdeckeinrichtungen können wie die Aufnahmeeinrichtungen ausgebildet sein. Die Abdeckeinrichtungen können beispielsweise ein metallisches Material aufweisen. Die Auflageflächen sind netz- oder gitterartig geformt und weisen eine Vielzahl kleiner Öffnungen 420 auf. Ebenso können auch gelochte Bleche verwendet werden.

Bei einem piezoelektrischen Aktorbauelement, bei dem die leitfähigen Innenelektrodenschichten aus Kupfer ausgebildet sind, können die Aufnahmeeinrichtungen 300 und die Abdeckeinrichtungen 400 ebenfalls ein Material aus Kupfer enthalten. Derartige Aufnahmeeinrichtungen beziehungsweise Abdeckeinrichtungen aus Kupfer ermöglichen, dass in einem Entbinderungs- beziehungsweise Sinterungsofen ein konstanter Partialdruck von Kupfer und Kupferoxiden während des Entbinderungsbeziehungsweise Sinterungsvorgangs auf allen Seitenflächen des Aktuatorbauelement herrscht. Da die Seitenflächen S100a der Aktorbauelemente auf den Auflageflächen der Abdeckeinrichtungen aufliegen und die Seitenflächen S100b auf den Auflageflächen 410 der Abdeckeinrichtungen 400 aufliegen, können mögliche Schwankungen im Sauerstoffpartialdruck während des Sintervorgangs stabilisiert werden.

Wenn die Innenelektrodenschichten der Aktuatorbauelemente aus Kupfer ausgebildet sind und die Aufnahmeeinrichtungen 300 beziehungsweise die Abdeckeinrichtungen 400 ebenfalls aus einem Material aus Kupfer ausgebildet sind, werden die Innenelektroden aus Kupfer während des Entbinderungs- beziehungsweise Sinterungsvorgangs vor einer Oxidation weitestgehend geschützt. Der in einem Entbinderungs- beziehungsweise Sinterungsofen enthaltene Sauerstoff reagiert zuerst mit dem Kupfer der Aufnahmeeinrichtungen beziehungsweise Abdeckeinrichtungen, so dass ein Oxidationsprozess zunächst an den Auflageflächen der Aufnahmeeinrichtungen und Abdeckeinrichtungen, nicht jedoch an den Elektrodenschichten im Inneren der Stapelanordnungen stattfindet. Um die Menge an Kupfer in der Umgebung der Aktorbauelemente zu erhöhen, kann auch die Trägerplatte 200 aus Kupfer gefertigt werden.

Das Anordnen der Schichtstapel der einzelnen piezoelektrischen Aktoren in den Aufnahmeeinrichtungen auf liegende Weise führt dazu, dass auf sämtliche in den Aufnahmeeinrichtungen eingelegten Aktorbauelemente die gleichen Umgebungsbedingungen wirken. Somit wird der Sauerstoffpartialdruck während der Entkohlung und Sinterung und der Bleioxidpartialdruck während der Sinterung homogen über alle vier Seiten jedes Aktorbauelements verteilt.

Die Aufnahmeeinrichtungen 300, die auf der Trägervorrichtung 200 angeordnet sind, verhindern zudem, dass Wechselwirkungen zwischen den Aktorbauelementen 1 und dem Material der Trägervorrichtung 200 auftreten. Des Weiteren ermöglichen die Öffnungen 320 in den Auflageflächen 310 der Aufnahmeeinrichtungen 300 beziehungsweise die Öffnungen 420 in den Auflageflächen 410 der Abdeckeinrichtungen 400 eine gute und gleichmäßige Zufuhr von Prozessgas zu sämtlichen vier Seitenflächen der Aktorbauelemente.

Die Aufnahmeeinrichtungen 300 sind komplementär zu den Abdeckeinrichtungen 400 ausgebildet. Wenn die Abdeckeinrichtungen 400 auf den Aufnahmeeinrichtungen 300 angeordnet werden, entstehen zwischen den Auflageflächen 310 der Aufnahmeeinrichtungen und den Auflageflächen 410 der Abdeckeinrichtungen Nester, in denen die Stapelanordnungen der piezoelektrischen Aktoren eingelegt werden können. Durch diese Nester werden für die Aktorbauelemente isolierte Bereiche geschaffen, in denen konstante Umgebungsbedingungen herrschen. Somit wird für jeden Stapel 100 der piezoelektrischen Aktorbauelemente eine homogene, stationäre Atmosphäre geschaffen.

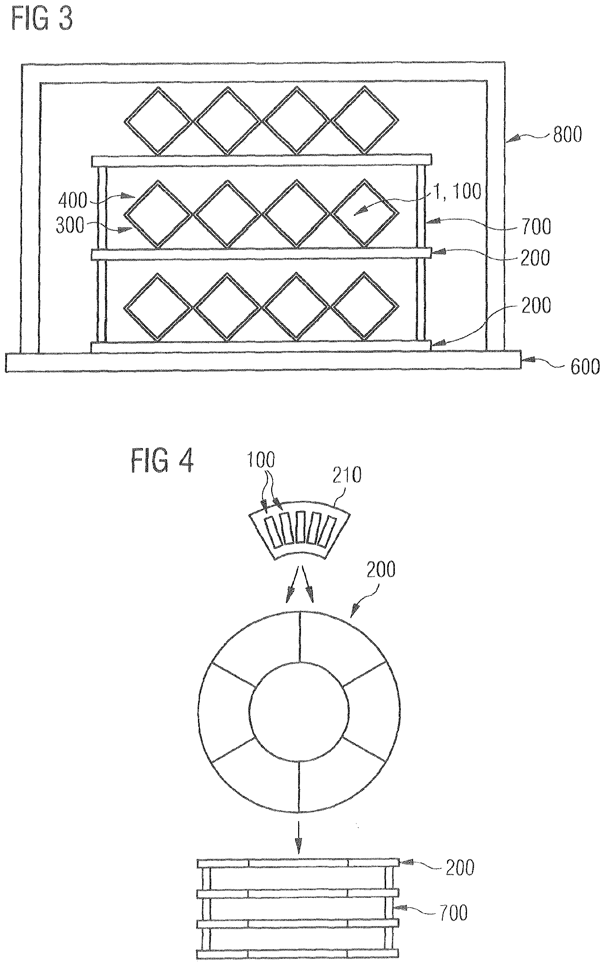

Figur 3 zeigt eine weitere Ausführungsform des Verfahrens zur Herstellung der piezoelektrischen Aktorbauelemente. Dabei werden mehrere Trägervorrichtungen 200 bereitgestellt, auf denen piezoelektrischen Aktorbauelemente liegend angeordnet werden. Die einzelnen piezoelektrischen Aktorbauelemente sind in den Aufnahmeeinrichtungen 300 angeordnet und werden von den Abdeckeinrichtungen 400 abgedeckt.

Mehrere derartiger Trägervorrichtung 200 mit den in den Nestern der Aufnahme- und Abdeckeinrichtungen liegend angeordneten Aktorbauelementen 1 werden auf einem Grundträger 600 übereinander gestapelt. Die Trägervorrichtungen 200 sind dabei durch Abstandshalter 700 voneinander beabstandet angeordnet. Die Abstandshalter 700 können als Abstandsbolzen ausgebildet sein, die der Separation der einzelnen Trägerplatten 200 voneinander dienen.

Zusätzlich können die übereinander gestapelten Trägervorrichtungen von einer Abdeckvorrichtung 800 abgedeckt sein. Die Abdeckvorrichtung 800 kann beispielsweise rechteckig ausgebildet sein. Die Abdeckung der übereinander gestapelt angeordneten piezoelektrischen Bauelemente mit einer Abdeckvorrichtung 800 sollte jedoch nur bei der Sinterung angewandt werden. Bei der Entkohlung würde ein Deckel den Abtransport von Crackprodukten von organischen Bindern verhindern. Die Abdeckvorrichtung 800 ist vorzugsweise aus einem Material aus Kupfer ausgebildet, was zu einer weiteren Stabilisierung der Atmosphäre im Sinterungsofen führt.

Figur 4 zeigt eine weitere Ausführungsform des Verfahrens zur Herstellung, insbesondere zum Entbindern und Sintern, von piezoelektrischen Aktorschichtstapeln 100. Die Trägervorrichtung 200 umfasst eine Vielzahl von kreissegmentförmigen Trägerelementen 210. Die Trägerelemente können aus einem keramischen Material, beispielsweise einer Aluminiumoxid-Keramik oder einer Magnesiumoxid-Keramik ausgebildet sein, die mit einer dünnen Kupferschicht beschichtet ist.

Die einzelnen kreissegmentförmigen Trägerelement 210 werden in einem Entbinderungs- beziehungsweise Sinterungsofen derart angeordnet, dass die Trägervorrichtung 200 die Form eines geschlossenen Kreisrings aufweist. Auf jedem der Trägerelemente werden die Stapelanordnungen der Aktorbauelemente liegend angeordnet. Mehrere Ebenen solcher kreisringförmiger Trägervorrichtungen können übereinander in den Ofen eingebracht werden. Die einzelnen Trägervorrichtungen der verschiedenen Ebenen können mit Abstandshaltern 700 voneinander beabstandet im Ofen angeordnet werden.

Wenn der Entbindungs- beziehungsweise Sinterungsofen einen runden Grundriss aufweist, wobei Heizelemente auf einer Außenseite des Ofens und/oder auf einer zentralen Achse im Ofen angeordnet sind, und Rohre für die Zufuhr von Prozessgasen, beispielsweise Stickstoff, Wasserstoff und Wasserdampf, ebenfalls auf einer äußeren Seite eines zylinderförmigen Innenraums des Ofens angeordnet sind, ermöglicht die Verwendung von derartigen kreissegmentförmigen Trägerelementen, auf denen die einzelnen Aktoren liegend nebeneinander angeordnet sind, die Realisierung einer homogenen Umgebung für jeden einzelnen Aktuator.

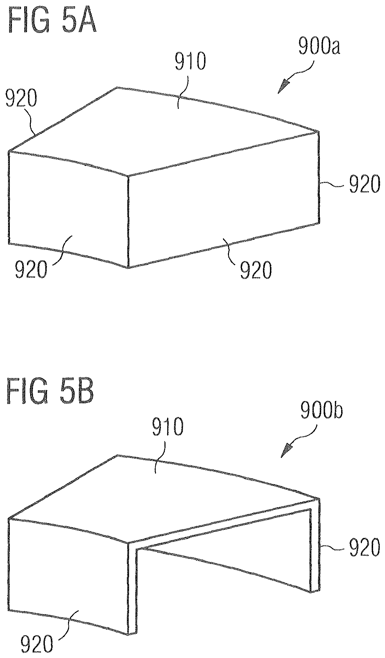

Um die Homogenität der Umgebung weiter zu erhöhen, können die Aktorbauelemente zusätzlich mit einem Abdeckelement 900 abgedeckt werden. Die Figuren 5A und 5B zeigen verschiedene Ausführungsformen von Abdeckelementen 900a, 900b, die insbesondere zur Abdeckung der kreissegmentförmige Trägerelemente 210 verwendet werden können. Die Abdeckelemente 900a und 900b weisen jeweils ein Oberteil 910 und Seitenteile 920 auf.

Bei der in Figur 5A gezeigten Ausführungsform des Abdeckelementes 900a sind vier Seitenteile 920 vorgesehen. Die Seitenteile 920 werden auf das Trägerelement 210 aufgesetzt. Das Oberteil 910 ist danach durch die Seitenteile 920 von der Trägervorrichtung 200 beabstandet angeordnet.

Bei der in Figur 5B gezeigten Ausführungsform des Abdeckelements 900b sind lediglich zwei Seitenteile vorgesehen, wobei die in Figur 5A vorgesehenen Seitenteile zu den Nachbarsegmenten der Trägerelemente fehlen. Bei dieser Ausführungsform können die Abdeckelemente auf der in Figur 4 gezeigten kreisringförmigen Trägervorrichtung nebeneinander zu einem kontinuierlichen Ring zusammengesetzt werden, was einem idealen homogenen Aufbau entspricht.

### Bezugszeichenliste

- 1: Piezoelektrisches Aktuatorbauelement
- 10, 20: Leitfähige Schichten/Elektrodenschichten
- 30: Piezoelektrisches Material
- 100: Stapelanordnung eines piezoelektrischen Aktorbauelements
- 200: Trägervorrichtung
- 210: Kreissegmentförmiges Trägerelement
- 300: Aufnahmeeinrichtung
- 310: Auflagefläche
- 320: Öffnung
- 400: Abdeckeinrichtung
- 410: Auflagefläche
- 420: Öffnung
- 500: Nest
- 600: Grundträger
- 700: Abstandshalter
- 800: Abdeckvorrichtung
- 900: Abdeckelement

## Patentansprüche

1. Verfahren zur Herstellung von piezoelektrischen Aktuatorbauelementen, umfassend:
- Bereitstellen einer Vielzahl von Stapelanordnungen (100) piezoelektrischer Aktuatorbauelemente (1), wobei die Stapelanordnungen (100) jeweils piezoelektrische Schichten (30) und leitfähige Schichten (10, 20) umfassen, und wobei die piezoelektrischen Schichten (30) in einer Längsrichtung der Stapelanordnung übereinander gestapelt sind und die leitfähigen Schichten (10, 20) zwischen den piezoelektrischen Schichten (30) angeordnet sind,
- Bereitstellen einer Vielzahl von Aufnahmeeinrichtungen (300) zur Aufnahme der Vielzahl der Stapelanordnungen (100), wobei jede der Aufnahmeeinrichtungen eine Auflagefläche (310) zur Auflage von einer der Vielzahl der Stapelanordnungen (100) aufweist, wobei die Auflagefläche Öffnungen (320) aufweist, wobei die Öffnungen (320) in der Auflagefläche (310) derart verteilt angeordnet sind, dass eine Seitenfläche (S100a) der einen der Vielzahl der Stapelanordnungen (100), mit der die eine der Stapelanordnungen (100) auf der Auflagefläche (310) aufliegt, mit einem Gas aus der Umgebung der Aufnahmeeinrichtungen (300) in Kontakt steht,
- Anordnen der Vielzahl der Stapelanordnungen (100) auf einer Trägervorrichtung (200) derart, dass die Stapelanordnungen (100) jeweils in der Längsrichtung der Stapelanordnungen nebeneinander liegend auf der Trägervorrichtung (200) angeordnet sind,
- Anordnen der Vielzahl der Stapelanordnungen (100) in den Aufnahmeeinrichtungen (310) jeweils derart, dass die jeweilige Seitenfläche (S100a) der Stapelanordnungen (100) auf der Auflagefläche (310) aufliegt,
- Zuführen eines Prozessgases zu den Stapelanordnungen (100),
- Entbindern und/oder Sintern der Vielzahl der Stapelanordnungen (100), wobei die Stapelanordnungen (100) während des Entbinderns und/oder Sinterns auf der Trägervorrichtung (200) nebeneinander liegend angeordnet sind.

2. Verfahren nach Anspruch 1, umfassend:
- Bereitstellen einer Vielzahl von Abdeckeinrichtungen (400) zum Abdecken der Vielzahl der Stapelanordnungen (100), wobei jede der Abdeckeinrichtungen eine Auflagefläche (410) zur Auflage der jeweiligen der Abdeckeinrichtungen auf einer weiteren Seitenfläche (S100b) jeweils einer der Vielzahl der Stapelanordnungen (100) aufweist, wobei die Auflagefläche (410) Öffnungen (420) aufweist, wobei die Öffnungen (420) in der Auflagefläche (410) derart verteilt sind, dass die weitere Seitenfläche (S100b) der jeweils einen der Vielzahl der Stapelanordnungen (100) mit dem Gas aus der Umgebung der Abdeckeinrichtungen (400) in Kontakt steht,
- Anordnen der Vielzahl der Abdeckeinrichtungen (400) über der Vielzahl der Stapelanordnungen (100) derart, dass die Auflagefläche (420) einer jeweiligen der Abdeckeinrichtungen (400) auf der weiteren Seitenfläche (S100a) einer der Stapelanordnungen (100) aufliegt.

3. Verfahren nach Anspruch 2,
wobei die Auflageflächen (310) der Aufnahmeeinrichtungen (300) und die Auflageflächen (410) der Abdeckeinrichtungen (400) jeweils als ein gefaltetes Netz, ein Gitter oder ein gelochtes Blech ausgebildet sind.

4. Verfahren nach einem der Ansprüche 1 bis 3,
- wobei die Vielzahl der Stapelanordnungen (100) auf mehreren der Trägervorrichtungen (200) angeordnet werden,
- wobei die mehreren der Trägervorrichtungen (200) übereinander gestapelt in einem Ofen (1000) zum Entbindern und/oder Sintern der Vielzahl der Stapelanordnungen angeordnet werden.

5. Verfahren nach Anspruch 4,
wobei zwischen den übereinander gestapelten Trägervorrichtungen (200) Abstandshalter (700) angeordnet werden.

6. Verfahren nach einem der Ansprüche 1 bis 5,
wobei eine Abdeckvorrichtung (800) über der Trägervorrichtung (200) oder über den mehreren übereinander gestapelten Trägervorrichtungen (200) angeordnet wird.

7. Verfahren nach einem der Ansprüche 1 bis 6, umfassend:
- Bereitstellen der Trägervorrichtung (200) in einer Ausgestaltungsform aus einer Vielzahl von kreissegmentförmigen Trägerelementen (210),
- Anordnen der Vielzahl der Trägerelemente (210) in einem Ofen (1000) zum Entbindern und/oder Sintern derart, dass die Trägervorrichtung (200) kreisringförmig ausgebildet wird.

8. Verfahren nach Anspruch 7, umfassend:
Anordnen eines Abdeckelements (900) über jeder der Trägerelemente (210), wobei das Abdeckelement ein kreissegmentförmiges Oberteil (910) und mindestens zwei Seitenteile (920) aufweist, wobei das Oberteil (910) zu dem jeweiligen Trägerelement (910) beabstandet angeordnet ist und die mindestens zwei Seitenteile (920) auf dem jeweiligen Trägerelement (910) aufliegen.

9. Verfahren nach einem der Ansprüche 2 bis 8, umfassend:
- Bereitstellen der Trägervorrichtung (200) mit einer oberflächlichen Beschichtung aus Kupfer,
- Bereitstellen der Vielzahl der Aufnahmeeinrichtungen (300) und der Vielzahl der Abdeckeinrichtungen (400) aus einem Material aus Kupfer.

## Claims

1. Method for producing piezoelectric actuator components, comprising:
- providing a multiplicity of stack arrangements (100) of piezoelectric actuator components (1), wherein the stack arrangements (100) in each case comprise piezoelectric layers (30) and conductive layers (10, 20), and wherein the piezoelectric layers (30) are stacked one above another in a longitudinal direction of the stack arrangement and the conductive layers (10, 20) are arranged between the piezoelectric layers (30),
- providing a multiplicity of receptacle devices (300) for receiving the multiplicity of stack arrangements (100), wherein each of the receptacle devices has a support surface (310) for supporting one of the multiplicity of stack arrangements (100), wherein the support surface has openings (320), wherein the openings (320) are arranged in a distributed fashion in the support surface (310) in such a way that a side surface (S100a) of one of the multiplicity of stack arrangements (100) by which said one of the stack arrangements (100) bears on the support surface (310) is in contact with a gas from the surroundings of the receptacle devices (300),
- arranging the multiplicity of stack arrangements (100) on a carrier apparatus (200) in such a way that the stack arrangements (100) are arranged on the carrier apparatus (200) in a manner lying alongside one another in each case in the longitudinal direction of the stack arrangements,
- arranging the multiplicity of stack arrangements (100) in the receptacle devices (310) in each case in such a way that the respective side surface (S100a) of the stack arrangements (100) bears on the support surface (310),
- feeding a process gas to the stack arrangements (100),
- removing binder from and/or sintering the multiplicity of stack arrangements (100), wherein the stack arrangements (100) are arranged in a manner lying alongside one another on the carrier apparatus (200) during the process of removing binder and/or sintering.

2. Method according to Claim 1, comprising:
- providing a multiplicity of covering devices (400) for covering the multiplicity of stack arrangements (100), wherein each of the covering devices has a support surface (410) for supporting the respective one of the covering devices on a further side surface (S100b) of a respective one of the multiplicity of stack arrangements (100), wherein the support surface (410) has openings (420), wherein the openings (420) are distributed in the support surface (410) in such a way that the further side surface (S100b) of the respective one of the multiplicity of stack arrangements (100) is in contact with the gas from the surroundings of the covering devices (400),
- arranging the multiplicity of covering devices (400) above the multiplicity of stack arrangements (100) in such a way that the support surface (420) of a respective one of the covering devices (400) bears on the further side surface (S100a) of one of the stack arrangements (100).

3. Method according to Claim 2,
wherein the support surfaces (310) of the receptacle devices (300) and the support surfaces (410) of the covering devices (400) are embodied in each case as a folded mesh, a grid or a perforated sheet.

4. Method according to any of Claims 1 to 3,
- wherein the multiplicity of stack arrangements (100) are arranged on a plurality of the carrier apparatuses (200),
- wherein the plurality of the carrier apparatuses (200) are arranged in a manner stacked one over another in a furnace (1000) for removing binder from and/or sintering the multiplicity of stack arrangements.

5. Method according to Claim 4,
wherein spacers (700) are arranged between the carrier apparatuses (200) stacked one above another.

6. Method according to any of Claims 1 to 5,
wherein a covering apparatus (800) is arranged above the carrier apparatus (200) or above the plurality of carrier apparatuses (200) stacked one above another.

7. Method according to any of Claims 1 to 6, comprising:
- providing the carrier apparatus (200) in a configurational form composed of a multiplicity of circle-segment-shaped carrier elements (210),
- arranging the multiplicity of carrier elements (210) in a furnace (1000) for removing binder and/or sintering in such a way that the carrier apparatus (200) is embodied in an annular fashion.

8. Method according to Claim 7, comprising:
arranging a covering element (900) above each of the carrier elements (210), wherein the covering element has a circle-segment-shaped upper part (910) and at least two side parts (920), wherein the upper part (910) is arranged at a distance from the respective carrier element (910) and the at least two side parts (920) bear on the respective carrier element (910).

9. Method according to any of Claims 2 to 8, comprising:
- providing the carrier apparatus (200) with a superficial coating of copper,
- providing the multiplicity of receptacle devices (300) and the multiplicity of covering devices (400) from a material composed of copper.

## Revendications

1. Procédé de fabrication de composants actionneurs piézoélectriques, consistant à :
- fournir une pluralité d'empilements (100) de composants actionneurs piézoélectriques (1), dans lequel les empilements (100) comprennent respectivement des couches piézoélectriques (30) et des couches conductrices (10, 20), et dans lequel les couches piézoélectriques (30) sont empilées les unes sur les autres dans une direction longitudinale de l'empilement et les couches conductrices (10, 20) sont disposées entre les couches piézoélectriques (30),
- fournir une pluralité de dispositifs de réception (300) pour recevoir la pluralité de empilements (100), dans lequel chacun des dispositifs de réception comporte une surface d'appui (310) destinée à la mise en place de l'un de la pluralité de empilements (100), dans lequel la surface d'appui comporte des ouvertures (320), dans lequel les ouvertures (320) sont disposées de manière répartie dans la surface d'appui (310) afin qu'une surface latérale (S100a) de l'un de la pluralité de empilements (100), au moyen duquel ledit un des empilements (100) repose sur la surface d'appui (310), soit en contact avec un gaz provenant de l'environnement des dispositifs de réception (300),
- disposer la pluralité de empilements (100) sur un dispositif de support (200) de manière à ce que les empilements (100) soient respectivement disposés dans la direction longitudinale des empilements en étant situés côte à côte sur le dispositif de support (200),
- disposer respectivement la pluralité de empilements (100) dans les dispositifs de réception (310) afin que la surface latérale respective (S100a) des empilements (100) repose sur la surface d'appui (310),
- acheminer un gaz de traitement vers les empilements (100),
- délianter et/ou fritter la pluralité de empilements (100), dans lequel les empilements (100) sont disposés sur le dispositif de support (200) pendant le déliantage et/ou le frittage en étant situés côte à côté.

2. Procédé selon la revendication 1, consistant à :
- fournir une pluralité de dispositifs de recouvrement (400) pour recouvrir la pluralité de empilements (100), dans lequel chacun des dispositifs de recouvrement comporte respectivement une surface d'appui (410) destinée à la mise en place des dispositifs de recouvrement respectifs sur une autre surface latérale (S100b) de l'un de la pluralité de empilements (100), dans lequel la surface d'appui (410) comporte des ouvertures (420), dans lequel les ouvertures (420) sont réparties dans la surface d'appui (410) de manière à ce que l'autre surface latérale (S100b) de l'un, respectif, de la pluralité de empilements (100) soit en contact avec le gaz provenant de l'environnement des dispositifs de recouvrement (400),
- disposer la pluralité de dispositifs de recouvrement (400) sur la pluralité de empilements (100) afin que la surface d'appui (420) de l'un, respectif, des dispositifs de recouvrement (400) repose sur l'autre surface latérale (S100a) de l'un des empilements (100).

3. Procédé selon la revendication 2,
dans lequel les surfaces d'appui (310) des dispositifs de réception (300) et les surfaces d'appui (410) des dispositifs de recouvrement (400) sont respectivement réalisées sous la forme d'un maillage replié, d'une grille ou d'une tôle perforée.

4. Procédé selon l'une quelconque des revendications 1 à 3,
- dans lequel la pluralité de empilements (100) sont disposés sur plusieurs des dispositifs de support (200),
- dans lequel lesdits plusieurs dispositifs de support (200) sont disposés de manière empilée les uns sur les autres dans un four (1000) pour délianter et/ou fritter la pluralité de empilements.

5. Procédé selon la revendication 4,
dans lequel des écarteurs (700) sont disposés entre les dispositifs de support (200) empilés les uns sur les autres.

6. Procédé selon l'une quelconque des revendications 1 à 5,
dans lequel un dispositif de recouvrement (800) est disposé sur le dispositif de support (200) ou sur lesdits plusieurs dispositifs de support (200) empilés les uns sur les autres.

7. Procédé selon l'une quelconque des revendications 1 à 6, consistant à :
- fournir le dispositif de support (200) sous une forme de réalisation constituée d'une pluralité d'éléments de support (210) en forme d'anneaux circulaires,
- disposer la pluralité de éléments de support (210) dans un four (1000) pour le déliantage et/ou le frittage afin que le dispositif de support (200) soit réalisé en forme d'anneau circulaire.

8. Procédé selon la revendication 7, consistant à :
disposer un élément de recouvrement (900) sur chacun des éléments de support (210), dans lequel l'élément de recouvrement comporte une partie supérieure (910) en forme d'anneau circulaire et au moins deux parties latérales (920), dans lequel la partie supérieure (910) est disposée de manière espacée de l'élément de support respectif (910) et les au moins deux parties latérales (920) reposent sur l'élément de support respectif (910).

9. Procédé selon l'une quelconque des revendications 2 à 8, consistant à :
- fournir le dispositif de support (200) avec un revêtement superficiel constitué de cuivre,
- fournir la pluralité de dispositifs de réception (300) et la pluralité de dispositifs de recouvrement (400) constitués d'un matériau formé de cuivre.
